Europäisches Patentamt

European Patent Office

Office européen des brevets

(19)

(11) Numéro de publication: **0 055 670 B1**

(12) **FASCICULE DE BREVET EUROPEEN**

(45) Date de publication du fascicule du brevet:
**22.05.85**

(51) Int. Cl.⁴: **H 03 K 3/017**

(21) Numéro de dépôt: **81402071.5**

(22) Date de dépôt: **23.12.81**

(54) *Circuit de réglage du rapport cyclique d'un signal périodique impulsionnel et dispositif multiplicateur de fréquence par 2n, incluant ce circuit de réglage.*

(30) Priorité: **29.12.80 FR 8027670**

(43) Date de publication de la demande:
**07.07.82 Bulletin 82/27**

(45) Mention de la délivrance du brevet:
**22.05.85 Bulletin 85/21**

(84) Etats contractants désignés:
**DE GB NL**

(56) Documents cités:
**US - A - 3 646 370**

**ELECTRONICS, vol. 48, no. 15, 24 juillet 1975 New York, US H.P.D. LANYON: "One-shot with feedback loop maintains constant duty cycle", pages 93-95**
**THE ELECTRONIC ENGINEER, vol. 30, no. 1, janvier 1971 Radnor, US K. ERICKSON: "One-shot triggers on both edges of input", page 45**
**ELECTRONICS, vol. 49, no. 15, 22 juillet 1976 New York, US R.L. TAYLOR: "Frequency-doubler produces square-wave output", pages 111 et 113**
**EDN ELECTRICAL DESIGN NEWS, vol. 23, no. 14, 5 août 1978 Denver, US P.A. LAWLESS: "One-shot forms frequency multiplier", page 72**

(73) Titulaire: **Chazenfus, Henri, 127, Rue Jeanne d'Arc, F-75013 Paris (FR)**

(72) Inventeur: **Chazenfus, Henri, 127, Rue Jeanne d'Arc, F-75013 Paris (FR)**

(74) Mandataire: **Mongrédien, André et al, c/o BREVATOME 25, rue de Ponthieu, F-75008 Paris (FR)**

## Description

La présente invention concerne un circuit de réglage du rapport cyclique d'un signal périodique impulsionnel ainsi qu'un dispositif multiplicateur par $2^n$ de la fréquence d'un signal impulsionnel, incluant ce circuit de réglage. Cette invention s'applique à la transmission numérique et notamment à la modulation par déplacement de phases, à quatre états.

Pour mieux comprendre l'application de l'invention, notamment à la modulation par déplacement de phases à quatre états, il est utile de rappeler que dans le domaine de la transmission numérique, le débit d'un signal modulant ou la quantité d'informations transmises par seconde (nombre d'éléments binaires par seconde), est associé à un signal d'horloge ou de rythme H, de fréquence $f_0$. Le signal d'horloge H est un signal rectangulaire de rapport cyclique 0,5. La modulation de phases à quatre états résulte de la composition de deux modulations, par déplacement de phases à deux états, pour lesqueles la fréquence du rythme associé est égale à $f_0/2$ et est appelée encore horloge H/2. Dans une chaîne de transmission, au niveau du modulateur, le signal modulant est séparé en deux trains numériques A et B dont les débits sont respectivement égaux à la moitié du débit du signal à transmettre. L'horloge associée H/2 est constituée en divisant par deux la fréquence de l'horloge H, généralement à l'aide d'une bascule. A la réception, la démodulation fournit aux erreurs de transmission près, les trains numériques A et B; elle permet également de retrouver le rythme ou signal d'horloge H/2. Pour reconstituer le signal modulant initial, par entrelaçage, il est nécessaire de reconstituer l'horloge H en doublant la fréquence du rythme de l'horloge H/2.

L'invention s'applique particulièrement à la mise en œuvre de cette dernière opération, c'est-à-dire à la transformation de l'horloge H/2 en horloge H.

Le dispositif multiplicateur de l'invention inclut aussi un circuit de réglage du rapport cyclique d'un signal impulsionnel. On ne connaît pas de dispositif simple qui permette de régler rapidement le rapport cyclique d'un signal périodique impulsionnel et on ne connaît pas non plus de dispositif multiplicateur simple qui permette de multiplier la fréquence d'un signal par deux ou par une puissance n de deux, sans faire intervenir des moyens nombreux, coûteux et difficiles à mettre en œuvre.

Parmi les dispositifs qui permettent de régler le rapport cyclique d'un signal impulsionnel, le plus simple d'entre eux est constitué par une bascule monostable dont on règle la durée de la période de conduction, en choisissant des valeurs appropriées pour les éléments capacitifs et résistifs qui permettent de fixer la durée de cette période. Ce réglage n'est pas très précis et il est spécifique de la fréquence du signal.

Les dispositifs doubleurs de fréquence connus sont, soit de type «analogique», soit de type «à boucle de verrouillage de phase».

Dans un doubleur de type analogique, le signal d'horloge H/2 de fréquence $f_0/2$ est appliqué au doubleur qui fait apparaître la raie de fréquence double: $f_0$. Il reste à réaliser un filtrage de la raie de fréquence $f_0$ de l'horloge H, puis une amplification suivie d'une remise en forme et d'une remise en phase.

Dans le cas d'un dispositif doubleur de fréquence utilisant une boucle à verrouillage de phase, un oscillateur commandé en tension fournit un signal de fréquence $f_0$, double de la fréquence $f_0/2$ de l'horloge H/2. Une comparaison de phases est ensuite effectuée entre le signal incident de fréquence $f_0/2$ et le signal de fréquence $f_0/2$ résultant de la division par deux du signal fourni par l'oscillateur commandé en tension. La tension d'erreur qui résulte de cette comparaison de phases, permet de verrouiller l'oscillateur commandé en tension sur la fréquence $f_0$, en fréquence et en phase. La sortie de l'oscillateur fournit le signal d'horloge H, de fréquence $f_0$.

Le doubleur de fréquence de type analogique comprend donc un filtre passe-bande accordé sur la fréquence $f_0$, un amplificateur de remise en forme et des moyens de remise en phase pour compenser le retard introduit par le filtrage. Ce type de doubleur a pour principal inconvénient d'être spécifique de chaque fréquence liée au débit numérique. De plus, la compensation de la plage d'incertitudes de la fréquence du signal incident est faible; enfin, pour les débits de faible vitesse, le filtrage doit être étroit pour séparer les raies de fréquence, ce qui augmente le retard à compenser.

Le doubleur de fréquence du type à «boucle de verrouillage de phase» est plus performant. Cependant, la plage d'accrochage et de poursuite de ce doubleur, sur la fréquence du signal d'entrée, est liée au facteur $K_0$ de l'oscillateur commandé en tension. Ce facteur $K_0$ est l'excursion de fréquence, couverte par volt de la tension de commande appliquée à l'oscillateur. Avec un oscillateur à quartz, ce facteur $K_0$ est de l'ordre de $10^{-3}$ à $10^{-4}$. Il en résulte que l'excursion de fréquence est très faible et que ce type de doubleur ne peut être que spécifique à chaque débit d'impulsions à transmettre. Avec un oscillateur classique, la gamme de débit contrôlée peut varier dans un rapport 4 entre le plus faible débit et le plus fort débit. Pour couvrir des plages plus importantes, il est nécessaire de recourir à des montages beaucoup plus complexes qui nécessitent des commutations de gammes.

Un autre système permettant de régler le rapport cyclique d'un signal périodique est décrit dans la revue «Electronics» – 24 juillet 1975 – pages 93 à 95. Ce système comprend:

– une bascule monostable qui reçoit le signal impulsionnel sur une entrée de déclenchement, cette bascule déclenchant sur le front montant de chaque impulsion du signal d'entrée,
– un comparateur constitué par un amplificateur opérationnel qui reçoit sur une de ses entrées le signal de sortie directe de la bascule monostable, la sortie de cet amplificateur étant reliée à une entrée de commande de la durée de conduction de la bascule monostable. L'une des deux entrées de cet amplificateur opérationnel est destinée au réglage du rapport cyclique des signaux de sortie de la bascule.

Ce type de système s'apparente aux circuits à boucle de verrouillage de phase et a pour inconvénient de couvrir des plages peu importantes de poursuite de fréquences de signaux d'entrée.

L'invention a pour but de remédier à ces inconvénients et notammment de réaliser un circuit de réglage du rapport cyclique d'un signal périodique impulsionnel, utilisant une bascule monostable dont la période de conduction est commandée, de manière simple, par le réglage de la tension de décalage des signaux appliqués aux entrées d'un amplificateur opérationnel disposé dans une boucle d'asservissement reliant les sorties de la bascule avec son entrée de contrôle de la période de conduction. Dans le cas de la bascule monostable utilisée, une tension continue appliquée sur cette entrée, permet de faire varier la période de conduction dans un rapport de l'ordre de 30.

L'invention a aussi pour but de réaliser un dispositif multiplicateur par $2^n$ de la fréquence d'un signal impulsionnel permettant une multiplication de fréquence dans de larges gammes de débits numériques, sans commutation, de conception simple et de réglage facile.

L'invention a pour objet un circuit de réglage du rapport cyclique d'un signal périodique impulsionnel, comprenant:

– une bascule monostable 1 qui reçoit le signal impulsionnel sur une entrée de déclenchement 2, cette bascule déclenchant sur le front montant de chaque impulsion du signal d'entrée,
– un comparateur 4 constitué par un amplificateur opérationnel qui reçoit sur une de ses entrées le signal de sortie directe Q de la bascule monostable, la sortie 7 de cet amplificateur étant reliée à une entrée $V_c$ de commande de la durée de conduction de la bascule monostable 1, l'amplificateur opérationnel comprenant en outre une entrée de réglage 8 du rapport cyclique des signaux de sortie de la bascule, caractérisé en ce que l'amplificateur opérationnel reçoit respectivement sur ses entrées les signaux des sorties directe et complémentaire de la bascule monostable, ladite entrée de réglage étant constituée par une entrée de commande de la tension de décalage des signaux appliqués sur les entrées de l'amplificateur opérationnel.

L'invention a aussi pour objet un dispositif multiplicateur par $2^n$ de la fréquence d'un signal impulsionnel, n étant un nombre entier supérieur ou égal à 1, caractérisé par le fait qu'il comprend, selon la valeur de n, l'association en série d'au moins un circuit de réglage de rapport cyclique selon l'alinéa précédent et d'au moins un circuit supplémentaire de structure identique à celle du circuit de réglage, l'entrée de basculement de la bascule monostable de ce circuit supplémentaire étant reliée à la sortie directe de la bascule monostable du circuit de réglage, la bascule monostable du circuit supplémentaire déclenchant sur les fronts montant et descendant de chaque impulsion reçue sur son entrée, l'amplificateur opérationnel du circuit supplémentaire qui est connecté entre les sorties de la bascule du circuit supplémentaire et l'entrée de commande de la période de conduction de cette bascule, comprenant aussi une entrée de commande de la tension de décalage des signaux appliqués à ses entrées, cette entrée de commande permettant de régler le rapport cyclique des signaux de sortie de la bascule du circuit supplémentaire, le rapport cyclique des signaux de sortie de la bascule du circuit de réglage étant réglé à la valeur 0,5.

Selon une autre caractéristique, le rapport cyclique des signaux de sortie de la bascule du circuit supplémentaire est réglé à la valeur 0,5.

D'autres caractéristiques et avantages de l'invention ressortiront mieux de la description qui va suivre, donnée en référence aux dessins annexés dans lesquels:

la fig. 1 représente schématiquement un circuit de réglage du rapport cyclique d'un signal périodique impulsionnel, conforme à l'invention;
la fig. 2 est un diagramme des signaux obtenus sur les sorties directe et complémentaire de la bascule monostable de ce circuit de réglage;
la fig. 3 représente schématiquement un dispositif multiplicateur de fréquence, conforme à l'invention;
la fig. 4 représente schématiquement un diagramme des signaux apparaissant sur les sorties de certains éléments de ce dispositif.

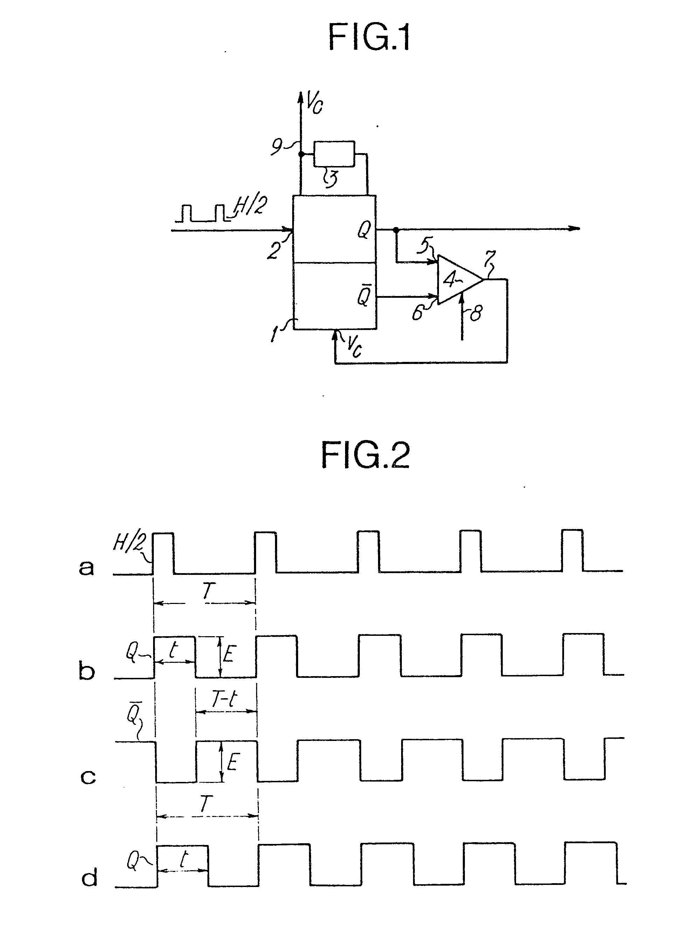

La fig. 1 représente schématiquement un circuit de réglage du rapport cyclique d'un signal périodique impulsionnel, conforme à l'invention. Ce circuit comprend une bascule monostable 1, qui reçoit sur son entrée de déclenchement 2, un signal impulsionnel de fréquence $f_0/2$ par exemple, tel que représenté sur le diagramme a de la fig. 2. On a représenté en 3, de manière schématique, le circuit à résistance/capacité qui permet de fixer la période de conduction résiduelle ou minimum de la bascule monostable. Le circuit de réglage comprend en outre un comparateur constitué par un amplificateur opérationnel 4, qui reçoit respectivement sur ses entrées 5, 6, les signaux des sorties directe Q, et complémentaire $\bar{Q}$ de la bascule monostable 1. La sortie de l'amplificateur opérationnel 4 est reliée à l'entrée de commande de période de conduction $V_c$ de la bascule monostable. Cet amplificateur présente en outre une entrée de commande 8 qui, de manière connue, permet de régler la tension de décalage des signaux appliqués aux entrées de l'amplificateur. Ce réglage permet, conformément à l'invention, de régler le rapport cyclique des signaux de sortie de la bascule monostable 1.

Les signaux qui sont utilisés ici sont ceux de la sortie directe Q de la bascule monostable. La bascule monostable de ce circuit de réglage déclenche, comme on le verra par la suite, sur les fronts montants des impulsions reçues sur l'entrée 2 de la bascule.

La fig. 2 représente respectivement en $\underline{a}$, $\underline{b}$, $\underline{c}$, et $\underline{d}$ les signaux impulsionnels appliqués à l'entrée 2 de la bascule, les signaux recueillis sur les sorties directe Q et complémentaire $\bar{Q}$ de celle-ci, en l'absence d'amplificateur opérationnel et le signal recueilli sur la sortie directe Q lorsque l'amplificateur opérationnel est présent entre les sorties de la bascule et son entrée de commande de la période de conduction $V_C$.

Les impulsions reçues sur l'entrée 2 de la bascule 1 et qui sont représentées sur le diagramme $\underline{a}$ permettent de déclencher cette bascule sur les fronts montants de ces impulsions et les signaux obtenus sur les sorties directe Q et complémentaire $\bar{Q}$ de la bascule sont représentés sur les diagrammes $\underline{b}$ et $\underline{c}$. En l'absence d'amplificateur opérationnel entre les sorties de la bascule et l'entrée de commande $V_C$ de celle-ci, le rapport cyclique $\frac{t}{T}$ des signaux impulsionnels de sortie de la bascule, dépend essentiellement de la constante de temps du circuit à résistance/capacité 3. L'amplificateur opérationnel 4, dont les entrées sont connectées aux sorties de la bascule monostable 1 et dont la sortie est reliée à l'entrée $V_C$ de cette bascule, permet, par réglage de la tension de décalage des signaux parvenant à l'entrée de cet amplificateur, de régler la fin de la période de conduction de la bascule monostable et donc de régler le rapport cyclique $\frac{t}{T}$ des signaux obtenus par exemple sur la sortie directe Q de la bascule. En effet, l'amplificateur opérationnel 4 fournit, en sortie, une tension d'erreur $\Delta V$ qui agit sur la durée de conduction de la bascule monostable. La valeur de cette tension d'erreur peut être ajustée par une tension continue réglable agissant sur l'entrée 8 de l'amplificateur opérationnel. La tension d'erreur, dans la boucle d'asservissement qui comprend l'amplificateur opérationnel 4, résulte de la comparaison de la valeur moyenne des signaux directs et complémentairs fournis par les sorties Q et $\bar{Q}$ de la bascule monostable. L'asservissement réalisé est tel que la tension d'erreur se stabilise lorsque le rapport cyclique $\frac{t}{T}$ du signal H/2 obtenu sur les sorties Q et $\bar{Q}$ de la bascule, tend vers la valeur 0,5 pour un réglage donné. Toute variation du rapport cyclique se traduit par un décalage de la tension d'erreur qui vient corriger cette variation et verrouille la constante de temps de la bascule monostable sur la demipériode T du signal d'horloge H/2. Le réglage qui vient d'être décrit permet d'obtenir sur la sortie directe Q, par exemple, le signal représenté sur le diagramme $\underline{d}$ de la fig. 2. Sur ce diagramme, $\frac{t}{T}$ est égal à 0,5. Ce réglage peut être effectué automatiquement pour une gamme de fréquences dont le rapport est de l'ordre de 25. Il est bien évident que le valeur du rapport $\frac{t}{T}$ fixée à 0,5 pour des applications particulières, notamment pour l'utilisation du circuit de réglage de rapport cyclique dans un dispositif conforme à l'invention et qui permet de multiplier par $2^n$ la fréquence d'un signal impulsionnel; ce rapport peut être bien entendu de valeur différente pour d'autres applications. La durée de conduction de la bascule monostable est fonction de la tension continue $V_C$ appliquée sur l'entrée de commande de la bascule monostable; cette tension permet de faire varier la constante de temps de la bascule monostable dans un rapport pouvant aller jusqu'à 25 ou 30.

Si l'on considère les diagrammes $\underline{b}$ et $\underline{c}$ de la fig. 2, qui représentent les signaux qui apparaissent sur ls sorties directe Q et complémentaire $\bar{Q}$ de la bascule monostable, lorsque le rapport cyclique de ces signaux est différent de 0,5 et si l'on désigne par E l'amplitude maximale du signal impulsionnel obtenu sur la sortie directe Q de la bascule monostable, la valeur moyenne de ce signal est:

$$V = E \times \tfrac{t}{T}.$$

Dans le cas du diagramme $\underline{b}$, $V = \frac{E}{3}$ car $\frac{t}{T} = 1/3$. Si l'on considère ensuite le signal complémentaire qui apparaît sur la sortie Q, représenté sur le diagramme c la valeur moyenne de ce signal est: $V' = E \times \frac{(T-t)}{T}$ et, dans l'exemple représenté sur la figure, $V' = E \times \frac{2}{3}$ car $\frac{(T-t)}{T} = \frac{2}{3}$.

Lorsque le rapport cyclique est égal à 0,5, $t = \frac{t}{T}$ et $V = V' = \frac{E}{2}$. C'est cette valeur qui est choisie lorsque le circuit de réglage est utilisé dans un dispositif multiplicateur de fréquence par $2^n$, qui sera décrit plus loin en détail. En l'absence d'amplificateur opérationnel, les valeurs moyennes des tensions V et V' sur les sorties de la bascule monostable, sont différentes et il est possible d'écrire $V - V' = \Delta V$. Le rebouclage des sorties Q et $\bar{Q}$ de la bascule, sur son entrée de commande de la période de conduction, par l'intermédiaire d'un amplificateur opérationnel, permet, de faire tendre V vers V', en réglant bien entendu le rapport cyclique à une valeur de 0,5 pour une fréquence $f_0$ donnée, d'obtenir une tension d'erreur en sortie de l'amplificateur opérationnel. En réalité, le rapport cyclique est égal à 0,5 $(1+\varepsilon)$, $\varepsilon$ étant l'erreur résiduelle, et $\Delta V = E.\varepsilon$. L'amplificateur opérationnel délivre une tension d'erreur qui est fonction de la fréquence du signal incident, et grâce à son grand gain assure que $\Delta V$ est très faible, donc que le rapport cyclique est très proche de 0,5. Ainsi, on conserve ce même rapport cyclique sur une très large gamme de fréquence.

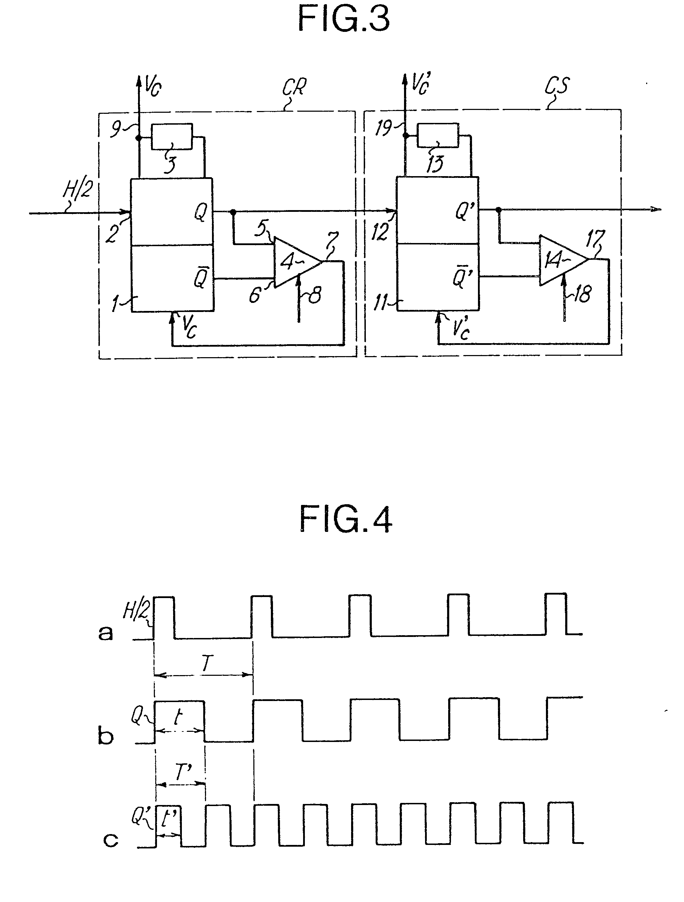

La fig. 3 représente un dispositif multiplicateur de fréquence d'un signal impulsionnel, par $2^n$. Ce dispositif multiplicateur inclut un circuit de réglage CR identique à celui de la fig. 1. Les mêmes éléments portent les mêmes références sur cette figure et sur la fig. 1. Bien entendu, le rapport cyclique des signaux d'horloge H/2 fournis par le circuit de réglage de CR, est fixé à la valeur 0,5, comme on l'a indiqué plus haut. Ce circuit de réglage est connecté en série avec un circuit supplémentaire CS, de structure identique à celle du circuit de réglage. Ce circuit supplémentaire comprend, comme le circuit de réglage, une bascule monostable 11 dont l'entrée de basculement 12 est reliée à la sortie directe Q de la bascule monostable du circuit de réglage CR. On a également représenté sur cette figure un circuit 13 à constante de temps RC, qui permet de fixer la durée de conduction résiduelle de la bascule monostable; l'entrée de commande V'$_c$ permet de faire varier la durée de conduction dans un rapport 25 à 30. Cette tension est également choisie pour que la bascule déclenche, sur les fronts montant et descendant, des impulsions reçues sur l'entrée de déclenchement 12. Les sorties directe Q' et complémentaire Q̄' de la bascule sont reliées respectivement aux entrées d'un amplificateur opérationnel 14, dont la sortie 17 est reliée à l'entrée de commande V'$_c$ de la bascule 11. Les signaux H de sortie du dispositif multiplicateur sont ceux qui sont fournis par la sortie directe Q'. Comme pour le circuit de réglage, l'amplificateur opérationnel 14 comprend une entrée de commande 18 qui permet de régler le décalage de tension des signaux d'entrée de cette amplificateur opérationnel de manière à fixer le rapport cyclique des signaux de sortie de ce circuit supplémentaire.

La fig. 4 est une diagramme des signaux qui apparaissent en certains points caractéristiques du dispositif de la fig. 3. Le diagramme a représente les signaux d'horloge H/2 appliqués à l'entrée 2 de la bascule 1 du circuit de réglage CR. Le diagramme b représente les signaux fournis par la sortie directe Q de la bascule 1 du circuit de réglage.

Comme on l'a mentionné plus haut, la bascule 1 de ce circuit de réglage déclenche sur le front montant des impulsions reçues sur son entrée et le rapport cyclique des signaux qu'elle délivre en sortie a été réglé de manière à être égal à 0,5. Le diagramme c représente les signaux obtenus sur la sortie directe Q' de la bascule monostable 11 du circuit supplémentaire CS. Cette bascule déclenche sur les fronts montant et descendant des impulsions reçues sur son entrée 12, en provenance de la sortie Q du circuit de réglage. Dans un mode particulier de réglage, qui correspond au diagramme c de la figure, le rapport cyclique $\frac{t'}{T'}$ des signaux de sortie de la bascule 11 du circuit supplémentaire CS est égal à 1/2. Il est bien évident que ce rapport cyclique $\frac{t'}{T'}$ pourrait être différent selon les applications recherchées du dispositif multiplicateur. La sortie Q' du circuit supplémentaire CS délivre donc des signaux impulsionnels H dont la fréquence f$_0$ est double de la fréquence f$_0$/2 des signaux H/2 reçus sur l'entrée 2 de la bascule 1 du circuit de réglage.

Dans le dispositif multiplicateur de fréquence qui vient d'être décrit, il est possible d'associer en série avec le circuit supplémentaire, d'autres circuits supplémentaires identiques et dont le rapport cyclique des signaux de sortie est réglé à la valeur 0,5, de manière à former un dispositif multiplicateur par 2$^n$. La valeur de n dépend bien entendu du nombre de circuits supplémentaires associés au dispositif précédemment décrit.

Le dispositif multiplicateur qui vient d'être décrit permet de doubler la fréquence f$_0$/2 de signaux impulsionnels H/2, dont la fréquence varie, par exemple, entre 850 kHz et 25 MHz. Lorsque le rapport cyclique des signaux de sortie de la bascule monostable du circuit supplémentaire est réglé à la valeur 0,5, les signaux observés sont des signaux carrés, tels que représentés sur le diagramme c de la fig. 4. La distorsion du rapport cyclique est liée à l'amplitude des harmoniques pairs du signal de sortie du dispositif. Le rapport de l'amplitude du signal utile à l'amplitude du premier harmonique pair est toujours supérieur à 40 décibels. L'écart des niveaux des signaux de sortie et des bascules monostables des circuits de réglage supplémentaire, est très facilement rattrapé par le réglage des tensions de décalage d'entrées (offset) des amplificateurs différentiels d'erreur de chaque circuit. Ce réglage, dans le cas où le rapport cyclique des signaux de sortie du dispositif multiplicateur doit être égal à 0,5, est effectué à l'initialisation du système à l'aide d'un analyseur de spectre. Le retard entre la sortie et l'entrée du dispositif est de l'ordre de 10 ns. La constante de temps minimum est de l'ordre 10 ns, le signal de sortie aura une fréquence maximum inférieure ou égale à 50 MHz. Le seuil de la durée de conduction minimum de chaque bascule est déterminé par l'utilisateur à l'aide des circuits à constante de temps 3,13, qui permettent de choisir la gamme de variation des constantes de temps. Il est ainsi possible, grâce à ces réglages, d'utiliser le dispositif dans une large gamme de fréquence; lorsque les réglages initiaux ont été effectués, les boucles d'asservissement apportent une autocompensation des défauts si le gain de chaque boucle est suffisant. Lorsque seul le circuit de réglage du rapport cyclique est utilisé, ce rapport cyclique peut varier entre 0,1 et 0,9 grâce au réglage de la tension d'offset de l'amplificateur opérationnel 4. Pour un réglage donné, il est possible d'obtenir un rapport cyclique fixe dans toute la gamme des fréquences.

Le dispositif multiplicateur qui vient d'être décrit peut être utilisé en transmission numérique notamment pour des débits compris entre 2,048 Meb/s. et 34,368 Meb/s., en modulation de phase à quatre états.

**Revendications**

1. Circuit de réglage du rapport cyclique d'un signal périodique impulsionnel, comprenant:

– une bascule monostable (1) qui reçoit le signal impulsionnel sur une entrée de déclenchement (2), cette bascule déclenchant sur le front montant de chaque impulsion du signal d'entrée,
– un comparateur (4) constitué par un amplificateur opérationnel qui reçoit sur une de ses entrées le signal de sortie directe (Q) de la bascule monostable, la sortie (7) de cet amplificateur étant reliée à une entrée (V$_c$) de commande de la durée de conduction de la bascule monostable (1), l'amplificateur opérationnel comprenant en outre une entrée de réglage (8) du rapport cyclique des signaux de sortie de la bascule, caractérisé en ce que l'amplificateur opérationnel reçoit respectivement sur ses entrées les signaux des sorties directe et complémentaire de la bascule monostable, ladite entrée de réglage étant constituée par une entrée de commande de la tension de décalage des signaux appliqués sur les entrées de l'amplificateur opérationnel.

2. Dispositif multiplicateur par 2$^n$ de la fréquence d'un signal impulsionnel, n étant un nombre entier supérieur ou égal à 1, ledit dispositif comprenant, selon la valeur de n, l'association en série d'au moins un circuit de réglage (CR) de rapport cyclique conforme à la revendication 1 et d'au moins un circuit supplémentaire (CS) de structure identique à celle du circuit de réglage (CR), l'entrée (12) de basculement de la bascule monostable de ce circuit supplémentaire étant reliée à la sortie directe (Q) de la bascule monostable (1) du circuit de réglage (CR), la bascule monostable (11) du circuit supplémentaire déclenchant sur les fronts montant et descendant de chaque impulsion reçue sur son entrée (12), l'amplificateur opérationnel (14) du circuit supplémentaire qui est connecté entre les sorties (Q, Q̄) de la bascule (11) du circuit supplémentaire (CS) et l'entrée (V'$_c$) de commande de la durée de conduction de cette bascule (11), comprenant aussi une entrée de commande (18) de la tension de décalage des signaux appliqués à ses entrées, cette entrée de commande (18) permettant de régler le rapport cyclique des signaux de sortie de la bascule (11) du circuit supplémentaire (CS), le rapport cyclique des signaux de sortie de la bascule (1) du circuit de réglage (CR) étant réglé à la valeur 0,5.

3. Disposititif multiplicateur selon la revendication 2, caractérisé en ce que le rapport cyclique des signaux de sortie de la bascule (11) du circuit supplémentaire (CS) est réglé à la valeur 0,5.

**Patentansprüche**

1. Schaltung zur Regelung des Tastverhältnisses eines periodischen Impulssignals, enthaltend:

– eine monostabile Kippstufe (1), die das Impulssignal an einem Triggereingang (2) erhält, wobei die Kippstufe bei der Anstiegsflanke jedes Eingangsimpulssignals triggert,
– einen Komparator (4), der von einem Operationsverstärker gebildet wird, der an einem seiner Eingänge das Signal des Direktausgangs (Q) der monostabilen Kippstufe erhält und dessen Ausgang (7) mit einem Steuereingang (V$_c$) für die Beeinflussung der Leitfähigkeitsdauer der monostabilen Kippstufe (1) verbunden ist und der weiterhin einen Regeleingang (8) für das Tastverhältnis der Ausgangssignale der Kippstufe aufweist, dadurch gekennzeichnet, dass der Operationsverstärker an seinen Eingängen das direkte und das komplementäre Ausgangssignal der monostabilen Kippstufe erhält und dass der Regeleingang von einem Steuereingang für die Verschiebespannung der an den Eingängen des Operationsverstärkers anliegenden Signale gebildet ist.

2. Anordnung zum Vervielfachen der Frequenz eines Impulssignals um den Faktor 2$^n$, wobei n eine ganze Zahl grösser oder gleich 1 ist, enthaltend gemäss dem Wert von n eine Serienschaltung von wenigstens einer Regelschaltung (CR) nach Anspruch 1 und wenigstens einen Zusatzkreis (CS) von mit der Regelschaltung (CR) identischem Aufbau, wobei der Triggereingang (12) der monostabilen Kippstufe des Zusatzkreises mit dem Direktausgang (Q) der monostabilen Kippstufe (1) der Regelschaltung (CR) verbunden ist, die monostabile Kippstufe (11) des Zusatzkreises auf den Vorderflanken und den Rückflanken jedes an seinem Eingang (12) empfangenen Impulses triggert, der Operationsverstärker (14) des Zusatzkreises zwischen die Ausgänge (Q, Q̄) der Kippschaltung (11) des Zusatzkreises (CS) und den Steuereingang (V'$_c$) für die Leitfähigkeitsdauer dieser Kippschaltung (11) geschaltet ist und auch einen Steuereingang (18) für die Verschiebespannung der an seinen Eingängen anliegenden Signale aufweist, der die Regelung des Tastverhältnisses der Ausgangssignale der Kippschaltung (11) des Zusatzkreises (CS) erlaubt, wobei das Tastverhältnis der Ausgangssignale der Kippschaltung (1) der Regelschaltung (CR) auf den Wert 0,5 geregelt ist.

3. Frequenzvervielfacheranordnung nach Anspruch 2, dadurch gekennzeichnet, dass das Tastverhältnis der Ausgangssignale der Kippstufe (11) des Zusatzkreises (CS) auf den Wert 0,5 geregelt ist.

**Claims**

1. Control circuit for the duty cycle of a periodic pulsed signal, comprising:

– a monostable multivibrator (1) which receives the pulsed signal at a trigger input (2), said multivibrator being triggered at the rising wave front of each pulse of the input signal,
– a comparator (4) constituted by an operational amplifier which receives at one of its inputs the signal from the direct output (Q) of the monostable multivibrator, the output (7) of said amplifier being connected to an input (V$_c$) commanding the duration of conduction of the monostable multivibrator (1), the operational amplifier additionally comprising a control input (8) for controlling the duty cycle of the output signals of the multivibrator, characterized in that the operational amplifier receives at its respective inputs the signals of the direct and complementary outputs of the monostable multivibrator, said control input being constituted by an input for commanding the voltage shift between the signals supplied at the inputs of the operational amplifier.

2. Device for multiplying by $2^n$ the frequence of a pulsed signal, $n$ being an integer greater than or equal to 1, said device comprising, depending upon the value of $n$, the association in series of at least one duty cycle control circuit (CR) according to Claim 1 and at least one supplementary circuit (CS) having a structure identical to that of the control circuit (CR), the trip input (12) of the monostable multivibrator of the supplementary circuit being connected to the direct output (Q) of the monostable multivibrator (1) of the control circuit (CR), the monostable multivibrator (11) of the supplementary circuit being triggered at the rising and falling wave fronts of each pulse received by its input (12), the operational amplifier (14) of the supplementary circuit, which is connected between the outputs (Q, Q) of the multivibrator (11) of the supplementary circuit (CS) and the input (V'$_c$) for command of the duration of conduction of said multivibrator (11), comprising also an input (18) commanding the voltage shift between the signals applied to its inputs, said command input (18) enabling control of the duty cycle of the output signals of the multivibrator (11) of the supplementary circuit (CS), the duty ratio of the output signals of the multivibrator (1) of the control circuit (CR) being adjusted to a value of 0.5

3. Multiplier device according to Claim 2, characterized in that the duty cycle of the output signals of the multivibrator (11) of the supplementary circuit (CS) is adjusted to a value of 0.5.

0 055 670

# FIG.1

# FIG.2

9

# FIG.3

# FIG.4